Europäisches Patentamt

European Patent Office

Office européen des brevets

(11) Veröffentlichungsnummer: **0 204 092 B1**

# EUROPÄISCHE PATENTSCHRIFT

(45) Veröffentlichungstag der Patentschrift: **29.05.91**

(51) Int. Cl.5: **G01D 5/36**, G01D 5/244, H03K 3/023

(21) Anmeldenummer: **86104354.5**

(22) Anmeldetag: **29.03.86**

(54) **Einrichtung zur Erzeugung wenigstens eines fehlergesicherten periodischen Rechtecksignals.**

(30) Priorität: **03.05.85 DE 3515933**

(43) Veröffentlichungstag der Anmeldung: **10.12.86 Patentblatt 86/50**

(45) Bekanntmachung des Hinweises auf die Patenterteilung: **29.05.91 Patentblatt 91/22**

(84) Benannte Vertragsstaaten: **AT CH DE FR GB IT LI NL SE**

(56) Entgegenhaltungen:
**DE-A- 2 020 393**
**DE-A- 2 810 235**
**GB-A- 2 000 406**
**US-A- 4 110 828**

**ELECTRONIC ENGINEERING, Band 47, Nr. 566, April 1975, Seiten 21,23,; L. VAN DEN STEEN: "Schmitt trigger with voltage-controlled trigger levels"**

**IBM TECHNICAL DISCLOSURE BULLETIN, Band 24, Nr. 10, März 1982, Seiten 5183-5184; G. GOLDRIAN et al.: "Photoamplifier with self-adjusting threshold for symmetrical out-** put pulses"

(73) Patentinhaber: **Dr. Johannes Heidenhain GmbH**
**Dr.-Johannes-Heidenhain-Strasse 5 Postfach 1260**
**W-8225 Traunreut(DE)**

(72) Erfinder: **Huber, Martin, Dipl.-Ing.**
**Laufing 2**
**W-8261 Asten(DE)**

## Beschreibung

Die Erfindung betrifft eine Einrichtung zur Erzeugung wenigstens eines fehlergesicherten periodischen Rechtecksignals gemäß dem Oberbegriff des Anspruchs 1.

Periodische Rechtecksignale werden insbesondere bei digitalen elektrischen Positionsmeßeinrichtungen gewonnen. Derartige Positionsmeßeinrichtungen werden beispielsweise bei Bearbeitungsmaschinen zur Messung der Relativlage eines Werkzeugs bezüglich eines zu bearbeitenden Werkstücks und bei Meßmaschinen zur Ermittlung der Lage und/oder der Abmessungen von Prüfobjekten eingesetzt.

Aus der DE-A-20 20 393 ist eine Einrichtung zur Fehlersicherung bei inkrementalen Meßsystemen bekannt, bei der zur Kontrolle des Phasenwinkels und/oder der Amplitudenhöhe an den beim Meßvorgang erzeugten phasenversetzten elektrischen Abtastsignalen das eine Abtastsignal gleichzeitig zwei parallel angeordneten Triggern eines Fenstertriggers zugeführt wird, denen ein Antivalenzgatter nachgeschaltet ist. Der erste Trigger besitzt eine obere Triggerschwelle und der zweite Trigger eine untere Triggerschwelle; die beiden Triggerschwellen verlaufen beidseitig symmetrisch zur Nullinie des Abtastsignals. Die aus den beiden Triggern gewonnenen unterschiedlichen Rechtecksignale werden im Antivalenzgatter logisch zu einem Rechtecksignal verknüpft; aus dem anderen Abtastsignal wird nach seiner Triggerung ein Impuls erzeugt. Das Rechtecksignal des Fenstertriggers und der Impuls beaufschlagen eine Kontrollschaltung, die feststellt, ob der Impuls in einen bestimmten Bereich des Rechtecksignals fällt.

In der DE-OS 27 29 697 ist eine lichtelektrische inkrementale Positionsmeßeinrichtung zur Messung der Relativlage zweier zueinander verschiebbarer Objekte angegeben, bei der eine Abtasteinheit bei der Abtastung einer Meßteilung zwei um 90° phasenverschobene periodische sinusförmige Abtastsignale liefert, die jeweils über einen Verstärker einer Triggerstufe zur Bildung jeweils eines periodischen Rechtecksignals zugeführt werden. Diese beiden periodischen Rechtecksignale werden einem Vorwärts-/Rückwärtszähler mit einem Richtungsdiskriminator zum vorzeichenrichtigen Zählen der Inkremente der Meßteilung zugeleitet. Die Zählergebnisse des Zählers stellen die Meßwerte für die gegenseitige Relativlage der beiden zueinander verschiebbaren Objekte dar.

Bei dieser Triggerung der beiden phasenverschobenen periodischen Abtastsignale kann aber wenigstens ein Rechtecksignal durch fehlerhaftes Arbeiten der zugehörigen Triggerstufe fehlerhafte Signalzustände aufweisen. Solche fehlerhaften Rechtecksignale können aber insbesondere bei Positionsmeßeinrichtungen zu fehlerhaften Positionsmeßwerten für die Relativlage der zueinander verschiebbaren Objekte führen, die bei derartigen hochpräzisen Meßeinrichtungen nicht tragbar sind.

Der Erfindung liegt die Aufgabe zugrunde, eine Einrichtung anzugeben, die auf einfache Weise die Erzeugung wenigstens eines fehlergesicherten periodischen Rechtecksignals ermöglicht.

Diese Aufgabe wird erfindungsgemäß durch die Merkmale des Anspruchs 1 gelöst.

Die mit der Erfindung erzielten Vorteile bestehen insbesondere darin, daß mit nur geringem Aufwand fehlergesicherte periodische Rechtecksignale erzeugt werden können, die insbesondere bei hochpräzisen Positionsmeßeinrichtungen eine Ermittlung einwandfreier Positionsmeßwerte erlauben.

Durch die Erhöhung der Meßsicherheit bei einer Positionsmeßeinrichtung infolge dieser einwandfreien Positionsmeßwerte werden bei einer Bearbeitungsmaschine, bei der eine solche Positionsmeßeinrichtung zum Einsatz kommt, Fehlzeiten und Ausschuß erheblich verringert und die Betriebssicherheit wesentlich erhöht.

Vorteilhafte Ausbildungen der Erfindung entnimmt man den Unteransprüchen.

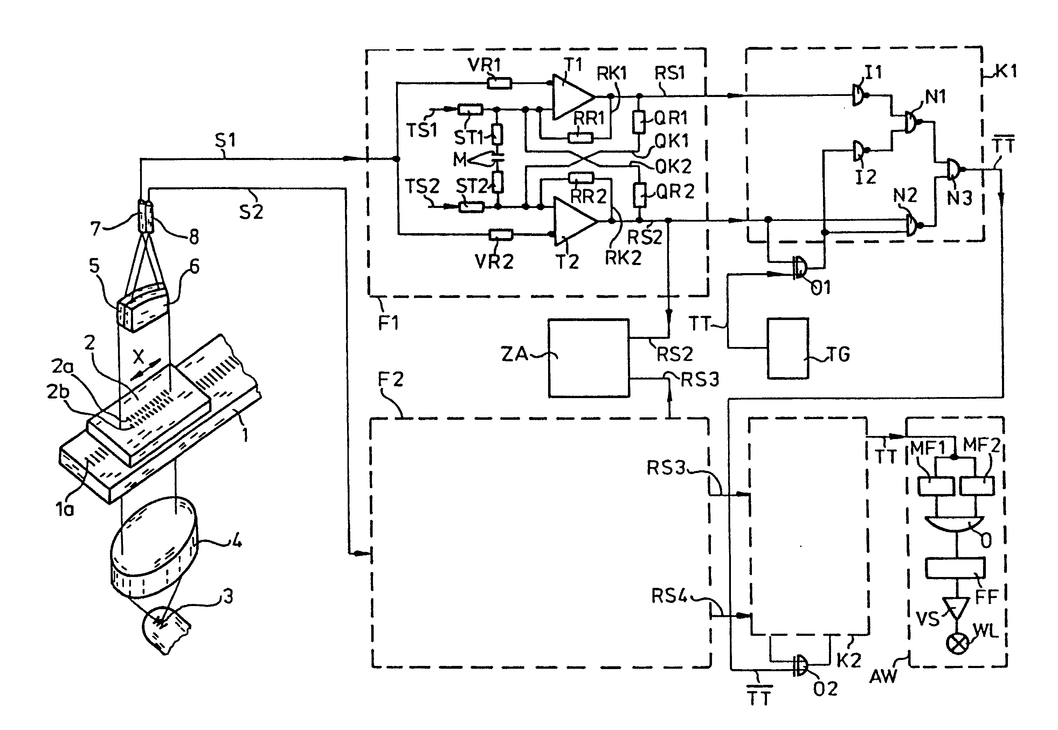

Ein Ausführungsbeispiel der Erfindung wird anhand der Zeichnung näher erläutert.

In der Figur ist schematisch eine lichtelektrische inkrementale Längenmeßeinrichtung zur richtungsabhängigen Wegmessung mit einem Gittermaßstab 1 und einer darüber gleitenden Gitterabtastplatte 2 einer Abtasteinheit dargestellt, die in nicht gezeigter Weise jeweils mit einem von zwei zueinander verschiebbaren Objekten, deren gegenseitige Relativlage gemessen werden soll, beispielsweise mit Maschinenteilen einer Bearbeitungsmaschine, verbunden sind. Die Gitterabtastplatte 2 weist zur Abtastung der inkrementalen Gitterteilung 1a des Gittermaßstabes 1 zwei Gitterteilungen 2a, 2b auf, die mit der Gitterteilung 1a des Gittermaßstabes 1 übereinstimmen und um ein Viertel ihrer Teilungsperiode zueinander versetzt sind. Der Lichtstrom einer Lampe 3 durchsetzt über einen Kondensor 4 die Gitterteilung 1a des Gittermaßstabes 1 und die beiden Gitterteilungen 2a, 2b der Gitterabtastplatte 2 und wird mittels Linsen 5, 6 auf zwei Photoelemente 7, 8 abgebildet, die jeweils einer der beiden Gitterteilungen 2a, 2b der Gitterabtastplatte 2 zugeordnet sind. Bei der Bewegung der Gitterabtastplatte 2 relativ zum Gittermaßstab 1 in Meßrichtung X erzeugen die beiden Photoelemente 7, 8 aus dem modulierten Lichtstrom zwei periodische elektrische sinusförmige Abtastsignale S1, S2, die einen gegenseitigen Phasenversatz von 90° wegen des Versatzes der beiden Gitterteilungen 2a, 2b der Gitterabtastplatte 2 um ein Viertel der Teilungsperiode aufweisen. Die Abtasteinheit umfaßt die Gitterabtastplatte 2, die Lampe 3, den Kondensor 4, die beiden Linsen 5, 6 und die beiden Photoelemente 7, 8.

Das erste periodische elektrische Abtastsignal S1 wird einer ersten Impulsformereinheit F1 zugeführt, der ein erster Vergleicher K1 nachgeschaltet ist, während das zweite periodische elektrische Abtastsignal S2 einer zweiten Impulsformereinheit F2 zugeleitet wird, der ein zweiter Vergleicher K2 nachgeschaltet ist. Die erste Impulsformereinheit F1 und die zweite Impulsformereinheit F2 sowie der erste Komparator K1 und der zweite Komparator K2 sind völlig gleichartig aufgebaut, so daß nachfolgend nur der Aufbau und die Wirkungsweise der ersten Impulsformereinheit F1 und des ersten Komparators K1 erläutert werden.

Das erste periodische elektrische Abtastsignal S1 beaufschlagt in der ersten Impulsformereinheit F1 gleichzeitig über einen ersten Vorwiderstand VR1 den invertierenden Eingang einer ersten Triggerstufe T1 und über einen zweiten Vorwiderstand VR2 den invertierenden Eingang einer parallel angeordneten zweiten Triggerstufe T2. Zwischen dem Ausgang der ersten Triggerstufe T1 und dem nichtinvertierenden Eingang der zweiten Triggerstufe T2 bestehen eine erste Querkopplung QK1 mit einem ersten Querkopplungswiderstand QR1 und zwischen dem Ausgang der zweiten Triggerstufe T2 und dem nichtinvertierenden Eingang der ersten Triggerstufe T1 eine zweite Querkopplung QK2 mit einem zweiten Querkopplungswiderstand QR2. Zusätzlich sind zwischen dem Ausgang und dem nichtinvertierenden Eingang der ersten Triggerstufe T1 eine erste Rückkopplung RK1 mit einem ersten Rückkopplungswiderstand RR1 und zwischen Ausgang und dem nichtinvertierenden Eingang der zweiten Triggerstufe T2 eine zweite Rückkopplung RK2 mit einem zweiten Rückkopplungswiderstand RR2 vorgesehen.

Zur Einstellung der ersten Triggerschwelle der ersten Triggerstufe T1 werden ihrem nichtinvertierenden Eingang über einen an Masse M angeschlossenen ersten Spannungsteiler ST1 eine erste Triggerschwellenspannung TS1 und zur Einstellung der zweiten Triggerschwelle der zweiten Triggerstufe T2 ihrem nichtinvertierenden Eingang über einen an Masse M angeschlossenen zweiten Spannungsteiler ST2 eine zweite Triggerschwellenspannung TS2 zugeführt. Die Spannungsversorgung der ersten Triggerstufe T1 und die Spannungsversorgung der zweiten Triggerstufe T2 erfolgen in nicht dargestellter Weise über separate Leitungen unabhängig voneinander.

Das von der ersten Triggerstufe T1 gelieferte erste periodische elektrische Rechtecksignal RS1 und das von der zweiten Triggerstufe T2 erzeugte zweite periodische elektrische Rechtecksignal RS2 sind durch die Parallelanordnung der beiden vom ersten periodischen elektrischen Abtastsignal S1 beaufschlagten Triggerstufen T1, T2 und durch die beiden Querkopplungen QK1, QK2 zwischen den beiden Triggerstufen T1, T2 identisch. Durch diese beiden Querkopplungen QK1, QK2 werden divergierende Schaltzustände der beiden Triggerstufen T1, T2 ausgeschlossen, das heißt, es wird sichergestellt, daß unter Erfassung sämtlicher herstellungsbedingter Toleranzen sowie temperaturbedingter und alterungsbedingter Drifterscheinungen der einzelnen Komponenten der ersten Impulsformereinheit F1 und bei beliebiger Stellung der Abtasteinheit 2-8 bezüglich des Gittermaßstabes 1 die beiden Triggerstufen T1, T2, die dem ersten periodischen Abtastsignal S1 zugeordnet sind, stets den gleichen Schaltzustand aufweisen und bei einer Relativbewegung zwischen der Abtasteinheit 2-8 und dem Gittermaßstab 1 gleichzeitig ihren Schaltzustand gleichsinnig ändern.

Dem ersten periodischen Abtastsignal S1 können neben den beiden vorgenannten Triggerstufen T1, T2 in nicht dargestellter Weise noch weitere parallele Triggerstufen zur Erhöhung der Redundanz zugeordnet werden. Im Hinblick auf die interne Fehlersicherheit der Impulsformereinheit F1 werden bevorzugt jeweils die Rückkopplungsgrade 1/RR1, 1/RR2 der ersten Rückkopplung RK1 der ersten Triggerstufe T1 und der zweiten Rückkopplung RK2 der zweiten Triggerstufe T2 größer als die zugehörigen Querkopplungsgrade 1/QR1, 1/QR2 der ersten Querkopplung QK1 der ersten Triggerstufe T1 und der zweiten Querkopplung QK2 der zweiten Triggerstufe T2 ausgelegt sowie der erste Rückkopplungswiderstand RR1 gleich dem zweiten Rückkopplungswiderstand RR2 und der erste Querkopplungswiderstand QR1 gleich dem zweiten Querkopplungswiderstand QR2 gewählt.

Zur Erkennung eines Fehlverhaltens einer oder beider Triggerstufen T1, T2 werden das erste periodische Rechtecksignal RS1 und das zweite periodische Rechtecksignal RS2 im Vergleicher K1 auf Gleichheit überprüft. Der Vergleicher K1 besteht aus einem ersten Inverter I1, dem das erste periodische Rechtecksignal RS1 zugeführt wird, und aus einem zweiten Inverter I2, dem ein periodisches Taktsignal TT eines Taktgenerators TG über den ersten Eingang eines ersten Antivalenzgatters 01 (Exklusiv-Odergatter) zugeleitet wird; die beiden Inverter I1, I2 sind an die Eingänge eines ersten Nandgatters N1 angeschaltet. Ein zweites Nandgatter N2 wird einmal vom zweiten periodischen Rechtecksignal RS2, das gleichzeitig am zweiten Eingang des ersten Antivalenzgatters 01 anliegt, und zum anderen vom Taktsignal TT über das erste Antivalenzgatter O1 beaufschlagt. Dem ersten Nandgatter N1 und dem zweiten Nandgatter N2 ist ein drittes Nandgatter N3 nachgeschaltet, an dessem Ausgang das invertierte periodische Taktsignal

$\overline{TT}$des Taktgenerators TG als periodisches Erkennungssignal für das Vorliegen einer Identität zwischen dem ersten periodischen Rechtecksignal RS1 und dem zweiten periodischen Rechtecksignal RS2 erscheint.

Das gegenüber dem ersten periodischen Abtastsignal S1 um ein Viertel der Teilungsperiode der Gitterteilung 1a des Gittermaßstabs 1 phasenversetzte zweite periodische Abtastsignal S2 wird der zweiten Impulsformereinheit F2 zur Erzeugung eines dritten periodischen Rechtecksignals RS3 und eines vierten periodischen Rechtecksignals RS4 zugeführt, die im zweiten Vergleicher K2 auf Identität verglichen werden. Das vom ersten Vergleicher K1 gelieferte invertierte periodische Taktsignal $\overline{TT}$im fehlerfreien Fall wird dem zweiten Vergleicher K2 über ein zweites Antivalenzgatter O2 zugeleitet, steht beim Vorliegen einer Gleichheit zwischen dem dritten und dem vierten periodischen Rechtecksignal RS3, RS4 als das ursprüngliche periodische Taktsignal TT am Ausgang des zweiten Vergleichers K2 an und wird einer Auswerteeinheit AW mit zwei parallelen monostabilen Kippstufen MF1, MF2 zugeleitet, denen ein Odergatter O, eine bistabile Kippstufe FF, ein Verstärker VS sowie eine Warnlampe WL nachgeschaltet sind. Bei einer Ungleichheit zwischen dem ersten und dem zweiten periodischen Rechtecksignal RS1, RS2 und/oder dem dritten und dem vierten periodischen Rechtecksignal RS3, RS4 weisen das invertierte periodische Taktsignal $\overline{TT}$am Ausgang des ersten Vergleichers K1 und/oder das ursprüngliche periodische Taktsignal TT am Ausgang des zweiten Vergleichers K2 eine Störung ihrer Periodizität auf, so daß die Warnlampe WL in der Auswerteeinheit AW auf diese Ungleichheit der entsprechenden periodischen Rechtecksignale RS1, RS2; RS3, RS4 anspricht. Die beiden Vergleicher K1, K2 sind eigenfehlersicher aufgebaut, so daß bei einem fehlerhaften Arbeiten dieser Vergleicher K1, K2 ebenfalls eine Störung der Periodizität des Taktsignals TT bzw. des Taktsignals $\overline{TT}$auftritt. Derartige Vergleicher K1, K2 sind beispielsweise in der DE-PS 22 07 224 beschrieben.

Von den beiden identischen und damit fehlergesicherten periodischen Rechtecksignalen RS1, RS2 werden das zweite periodische Rechtecksignal RS2 und von den beiden identischen und damit fehlergesicherten periodischen Rechtecksignalen RS3, RS4 das dritte periodische Rechtecksignal RS3 einer Zähler- und Anzeigeeinheit ZA mit einem Richtungsdiskriminator zum vorzeichenrichtigen Zählen der Inkremente der Gitterteilung 1a des Gittermaßstabes 1 bei der Abtastung durch die Abtasteinheit 2-8 und zur digitalen Anzeige der Positionsmeßwerte für die Relativlage der beiden zueinander verschiebbaren Objekte zugeführt.

Die Erfindung ist insbesondere sowohl bei absoluten als auch bei inkrementalen Längen- oder Winkelmeßeinrichtungen einsetzbar und zwar außer bei der beschriebenen lichtelektrischen Meßeinrichtung beispielsweise auch bei magnetischen, induktiven oder kapazitiven Meßeinrichtungen.

Bei einer absoluten Meßeinrichtung können die feinste Codespur auch mit inkrementalen Mitteln abgetastet und das auf diese Weise ermittelte "inkrementale" Meßergebnis mit dem "absoluten" Meßergebnis zur Überwachung der fehlerfreien Arbeitsweise der absoluten Meßeinrichtung verglichen werden. Bei dieser "inkrementalen" Abtastung kann die erfindungsgemäße Einrichtung mit Erfolg eingesetzt werden.

## Ansprüche

1. Einrichtung zur Erzeugung wenigstens eines fehlergesicherten periodischen Rechtecksignals aus wenigstens einem periodischen elektrischen Signal, insbesondere aus einem periodischen elektrischen Abtastsignal einer digitalen Positionsmeßeinrichtung zur Messung der Relativlage zweier zueinander verschiebbarer Objekte, dadurch gekennzeichnet, daß bei der das wenigstens eine periodische elektrische Signal (S1, S2) gleichzeitig wenigstens eine erste Triggerstufe (T1) zur Erzeugung wenigstens eines ersten periodischen Rechtecksignals (RS1) und wenigstens eine parallel angeordnete zweite Triggerstufe (T2) zur Erzeugung wenigstens eines zweiten periodischen Rechtecksignals (RS2) beaufschlagt, dadurch gekennzeichnet, daß die beiden Triggerstufen identische Triggerschwellen aufweisen, daß zwischen dem Ausgang der ersten Triggerstufe (T1) und dem Eingang der zweiten Triggerstufe (T2) eine erste Querkopplung (QK1) und zwischen dem Ausgang der zweiten Triggerstufe (T2) und dem Eingang der ersten Triggerstufe (T1) eine zweite Querkopplung (QK2) zur Synchronisierung der beiden periodischen Rechtecksignale (RS1, RS2) bestehen und daß das erste periodische Rechtecksignal (RS1) und das zweite periodische Rechtecksignal (RS2) in einem Vergleicher (K1) auf Gleichheit vergleichbar sind.

2. Einrichtung nach Anspruch 1, dadurch gekennzeichnet, daß das periodische elektrische Signal (S1) jeweils die invertierenden Eingänge der ersten Triggerstufe (T1) und der zweiten Triggerstufe (T2) beaufschlagt und daß die erste Querkopplung (QK1) aus einem ersten Querkopplungswiderstand (QR1) zwischen dem Ausgang der ersten Triggerstufe (T1) und dem nichtinvertierenden Eingang der zweiten Triggerstufe (T2) sowie die zweite Querkopplung (QK2) aus einem zweiten Querkopplungswiderstand (QR2) zwischen dem Ausgang der zweiten Triggerstufe (T2) und dem nichtinvertierenden Eingang der ersten Triggerstufe (T1) bestehen.

3. Einrichtung nach Anspruch 2, dadurch gekennzeichnet, daß zwischen dem Ausgang und dem nichtinvertierenden Eingang der ersten Triggerstufe (T1) eine erste Rückkopplung (RK1) aus einem ersten Rückkopplungswiderstand (RR1) sowie zwischen dem Ausgang und dem nichtinvertierenden Eingang der zweiten Triggerstufe (T2) eine zweite Rückkopplung (RK2) aus einem zweiten Rückkopplungswiderstand (RR2) bestehen.

4. Einrichtung nach Anspruch 2, dadurch gekennzeichnet, daß an den invertierenden Eingang der ersten Triggerstufe (T1) ein erster Vorwiderstand (VR1) und an den invertierenden Eingang der zweiten Triggerstufe (T2) ein zweiter Vorwiderstand (VR2) angeschaltet sind.

5. Einrichtung nach den Ansprüchen 2 und 3, dadurch gekennzeichnet, daß die Rückkopplungsgrade 1/RR1, 1/RR2 der ersten Rückkopplung (RK1) und der zweiten Rückkopplung (RK2) größer als die Querkopplungsgrade 1/QR1, 1/QR2 der ersten Querkopplung (QK1) und der zweiten Querkopplung (QK2) der beiden Triggerstufen (T1,T2) sind.

6. Einrichtung nach Anspruch 2, dadurch gekennzeichnet, daß der nichtinvertierende Eingang der ersten Triggerstufe (T1) mit einer ersten Triggerschwellenspannung (TS1) über einen ersten Spannungsteiler (ST1) und der nichtinvertierende Eingang der zweiten Triggerstufe (T2) mit einer zweiten Triggerschwellenspannung (TS2) über einen zweiten Spannungsteiler (ST2) beaufschlagt sind.

7. Einrichtung nach Anspruch 1, dadurch gekennzeichnet, daß der Vergleicher (K1) einen vom ersten periodischen Rechtecksignal (RS1) beaufschlagten ersten Inverter (I1) und einen vom einem periodischen Taktsignal (TT) eines Taktgebers (TG) über ein Antivalenzgatter (01) beaufschlagten zweiten Inverter (I2), denen ein erstes Nandgatter (N1) nachgeschaltet ist, sowie ein vom zweiten periodischen Rechtecksignal (RS2) und vom periodischen Taktsignal (TT) über das Antivalenzgatter (01) beaufschlagtes zweites Nandgatter (N2) aufweist und daß dem ersten Nandgatter (N1) und dem zweiten Nandgatter (N2) ein drittes Nandgatter (N3) nachgeschaltet ist, an dessem Ausgang das invertierte periodische Taktsignal ($\overline{TT}$) bei einer Gleichheit des ersten und des zweiten periodischen Rechtecksignals (RS1, RS2) ansteht.

8. Einrichtung nach Anspruch 7, dadurch gekennzeichnet, daß das periodische Taktsignal (TT) den ersten Eingang und das zweite periodische Rechtecksignal (RS2) den zweiten Eingang des Antivalenzgatters (01) beaufschlagen und daß der Ausgang des Antivalenzgatters (01) mit dem Eingang des zweiten Inverters (I2) und mit einem Eingang des zweiten Nandgatters (N2) des Vergleichers (K1) verbunden ist.

9. Einrichtung nach Anspruch 7, dadurch gekennzeichnet, daß dem Vergleicher (K1) eine Auswerteeinheit (AW) mit zwei parallelen monostabilen Kippstufen (MF1,MF2),einem Odergatter (O), einer bistabilen Kippstufe (FF), einem Verstärker (VS) und einer Warnlampe (WL) nachgeschaltet ist.

## Claims

1. Device for producing at least one error-free periodic square wave from at least one periodic electrical signal, especially from a periodic electrical sensing signal of a digital position measuring device for measuring the relative position of two mutually displaceable objects, in which the at least one periodic electrical signal (S1, S2) acts simultaneously on at least one first trigger stage (T1) for generating at least one first periodic square wave (RS1) and at least one second trigger stage (T2) disposed in parallel for generating at least one second periodic square wave (RS2), characterized in that the two trigger stages have identical trigger thresholds, in that there is a first cross coupling (QK1) between the output of the first trigger stage (T1) and the input of the second trigger stage (T2) and a second cross coupling (QK2) between the output of the second trigger stage (T2) and the input of the first trigger stage (T1) for synchronising the two periodic square waves (RS1 , RS2) and in that the first periodic square wave (RS1) and the second periodic square wave (RS2) are adapted to be compared for equality in a comparator (K1).

2. Device according to claim 1, characterized in that the periodic electrical signal (S1) acts on each of the inverting inputs of the first trigger stage (T1) and the second trigger stage (T2) and in that the first cross coupling (QK1) consists of a first cross coupling resistor (QR1) between the output of the first trigger stage (T1) and the non-inverting input of the second trigger stage (T2) and also the second cross coupling (QK2) consists of a second cross coupling resistor (QR2) between the output of the second trigger stage (T2) and the non-inverting input of the first trigger stage (T1).

3. Device according to claim 2, characterized in that there is a first feedback coupling (RK1) consisting of a first feedback coupling resistor (RR1) between the output and the non-inverting input of the first trigger stage (T1) and also a second feedback coupling (RK2) consisting of a second feedback coupling resistor (RR2) between the output and the non-inverting input of the second trigger stage (T2).

4. Device according to claim 2, characterized in that a first series resistor (VR1) is connected to the inverting input of the first trigger stage (T1) and a second series resistor (VR2) is connected to the inverting input of the second trigger stage (T2).

5. Device according to claims 2 and 3 characterized in that the feedback coupling factors 1/RR1, 1/RR2 of the first feedback coupling (RK1) and of the second feedback coupling (RK2) are greater than the cross coupling factors 1/QR1, 1/QR2 of the first cross coupling (QK1) and of the second cross coupling (QK2) of the two trigger stages (T1, T2).

6. Device according to claim 2, characterized in that the non-inverting input of the first trigger stage (T1) is responsive to a first trigger threshold voltage (TS1) through a first voltage divider (ST1) and the non-inverting input of the second trigger stage (T2) is responsive to a second trigger threshold voltage (TS2) through a second voltage divider (ST2).

7. Device according to claim 1, characterized in that the comparator (K1) comprises a first inverter (I1) responsive to the first periodic square wave (RS1) and a second inverter (I2) responsive to a periodic clock signal (TT) of a clock generator (TG) via an exclusive-OR gate (O1), which inverters are connected to a following first NAND gate (N1), as well as a second NAND gate (N2) responsive to the second periodic square wave (RS2) and the periodic clock signal (TT) via the exclusive-OR gate (O1), and in that a third NAND gate (N3) is connected after the first NAND gate (N1) and the second NAND gate (N2), at whose output the inverted periodic clock signal ($\overline{TT}$) appears with equality of the first and the second periodic square waves (RS1, RS2).

8. Device according to claim 7, characterized in that the periodic clock signal (TT) and the second periodic square wave (RS2) act on the first input and the second input respectively of the exclusive OR gate (O1) and in that the output of the exclusive OR gate (O1) is connected to the input of the second inverter (I2) and to one input of the second NAND gate (N2) of the comparator (K1).

9. Device according to claim 7, characterized in that there is connected after the comparator (K1) an evaluation unit (AW) with two parallel monostable multivibrators (MF1, MF2), an OR gate (O), a bistable flip-flop (FF), an amplifier (VS) and a warning lamp (WL).

## Revendications

1. Dispositif pour la production d'au moins un signal carré périodique protégé contre les erreurs à partir d'au moins un signal électrique périodique, notamment à partir d'un signal de palpage électrique périodique d'un dispositif de mesure de position numérique pour la mesure de la position relative de deux objets pouvant être déplacés l'un par rapport à l'autre, dans lequel au moins un signal électrique périodique (S1, S2) est appliqué simultanément à au moins un premier étage déclencheur (T1) pour la production d'au moins un premier signal carré périodique (RS1) et au moins un deuxième étage déclencheur (T2) monté en parallèle pour la production d'au moins un deuxième signal carré (RS2) périodique, *caractérisé* en ce que les deux étages déclencheurs ont des seuils de déclenchement identiques, en ce qu'il est prévu entre la sortie du premier étage déclencheur (T1) et l'entrée du deuxième étage déclencheur (T2) un premier couplage transversal (QK1) et entre la sortie du deuxième étage déclencheur (T2) et l'entrée du premier étage déclencheur (T1) un deuxième couplage transversal (QK2) pour la synchronisation des deux signaux carrés (RS1, RS2) périodiques, et en ce que le premier signal carré (RS1) périodique et le deuxième signal carré (RS2) périodique peuvent être comparés au niveau de leur égalité dans un comparateur (K1).

2. Dispositif selon 1a revendication 1, *caractérisé* en ce que le signal électrique (S1) périodique est appliqué chaque fois aux entrées inverseuses du premier étage déclencheur (T1) et du deuxième étage déclencheur (T2), et en ce que le premier couplage transversal (QK1) est constitué d'une première résistance de couplage transversal (QR1) placée entre la sortie du premier étage déclencheur (T1) et l'entrée non-inverseuse du deuxième étage déclencheur (T2), et le deuxième couplage transversal (QK2) est constitué d'une deuxième résistance de couplage transversal (QR2) placée entre la sortie du deuxième étage déclencheur (T2) et l'entrée non-inverseuse du premier étage déclencheur (T1).

3. Dispositif selon la revendication 2, *caractérisé* en ce qu'il est prévu entre la sortie et l'entrée non-inverseuse du premier étage déclencheur (T1) une première boucle de réaction (RK1) composée d'une première résistance de réaction (RR1), et entre la sortie et l'entrée non-inverseuse du deuxième étage déclencheur (T2), une deuxième boucle de réaction (RK2), composée d'une deuxième résistance de réaction (RR2).

4. Dispositif selon la revendication 2, *caractérisé* en ce qu'une première résistance série (VR1) est connectée à l'entrée inverseuse du premier étage déclencheur (T1), et une deuxième résistance série (VR2) est connectée à l'entrée inverseuse du deuxième étage déclencheur (T2).

5. Dispositif selon les revendications 2 et 3, *caractérisé* en ce que les taux de réaction 1/RR1, 1/RR2 de la première boucle de couplage (RK1) et de la deuxième boucle de couplage (RK2) sont supérieurs aux taux de couplage transversal 1/QR1, 1/QR2 du premier couplage transversal (QK1) et du deuxième couplage transversal (QK2) des deux étages déclencheurs (T1, T2).

6. Dispositif selon 1a revendication 2, *caractérisé* en ce qu'une première tension de seuil de déclenchement (TS1) est appliquée à l'entrée non-inverseuse du premier étage déclencheur (T1) par l'intermédiaire d'un premier diviseur de tension (ST1), et une deuxième tension de seuil de déclenchement (TS2) est appliquée à l'entrée non-inverseuse du deuxième étage déclencheur (T2) par l'intermédiaire d'un deuxième diviseur de tension (ST2).

7. Dispositif selon la revendication 1, *caractérisé* en ce que le comparateur (K1) comporte un premier inverseur (I1) recevant le premier signal carré (RS1) périodique, et un deuxième inverseur (I2) recevant le signal d'horloge (TT) périodique d'une horloge (TG) par l'intermédiaire d'une porte OU-exclusif (O1), suivie d'une première porte NON-ET (N1) ainsi qu'une deuxième porte NON-ET (N2) recevant le deuxième signal carré (RS2) périodique et le signal d'horloge (TT) périodique par l'intermédiaire de la porte OU-exclusif (O1), et en ce qu'une troisième porte NON-ET (N3) est placée derrière la première porte NON-ET (N1) et la deuxième porte NON-ET (N2), à la sortie de laquelle apparaît, en cas d'égalité du premier et du deuxième signal carré (RS1, RS2) périodique, le signal d'horloge (TT) périodique inversé.

8. Dispositif selon la revendication 7, *caractérisé* en ce que le signal d'horloge (TT) périodique est amené à la première entrée, et le deuxième signal carré (RS2) périodique est amené à la deuxième entrée de la porte OU-exclusif (O1), et que la sortie de la porte OU-exclusif (O1) est reliée à l'entrée du deuxième inverseur (I2) et à une entrée de la deuxième porte NON-ET (N2) du comparateur (K1).

9. Dispositif selon la revendication 7, *caractérisé* en ce que le comparateur (K1) est suivi d'une unité d'exploitation (AW) comportant deux étages basculeurs (MF1, MF2) monostables montés en parallèle, une porte OU (O), un étage bascule (FF) bistable, un amplificateur (VS) et une lampe témoin (WL).